# DEMANDE DE BREVET EUROPEEN

(11) **EP 0 686 509 A1**
(43) Date de publication de la demande: **13.12.1995**
(21) Numéro de dépôt: 95420143.0
(22) Date de dépôt: 06.06.1995
(51) Int. Cl.: B41M 1/10

(54) **Procédé d'impression par héliogravure avec des encres sans solvants**

(30) Priorité: 08.06.1994 FR 9407201
(71) Demandeur: PECHINEY EMBALLAGE ALIMENTAIRE, F-92115 Clichy (FR)
(72) Inventeur: Menu, Jean-Claude, F-21000 Dijon (FR); Layre, René, F-38100 Grenoble (FR)
(74) Mandataire: Mougeot, Jean-Claude

(57) **Abrégé**

Le procédé comprend, a) l'utilisation de cylindres gravés (1) en creux assurant un transfert d'encre (5) entre un encrier (6) et un support à imprimer (3), b) l'utilisation d'encres liquides, et c) l'utilisation de moyens de séchage de l'encre (16,17), caractérisé en ce que
1) on utilise des cylindres gravés (1) dont les alvéoles (4) sont de profondeur constante et de surface variable dans les limites de la surface du point de trame (21).
2) on utilise des encres liquides (5) sans solvants comprenant des monomères ou oligomères liquides, et de vitesse de polymérisation inférieure à 1 s,
3) on utilise, comme moyen de séchage, tout moyen connu pour fournir l'apport d'énergie adapté à ladite vitesse de polymérisation.

## Description

### DOMAINE DE L'INVENTION

L'invention concerne le domaine de l'impression de supports en bobines sur des rotatives par héliogravure.

### ETAT DE LA TECHNIQUE

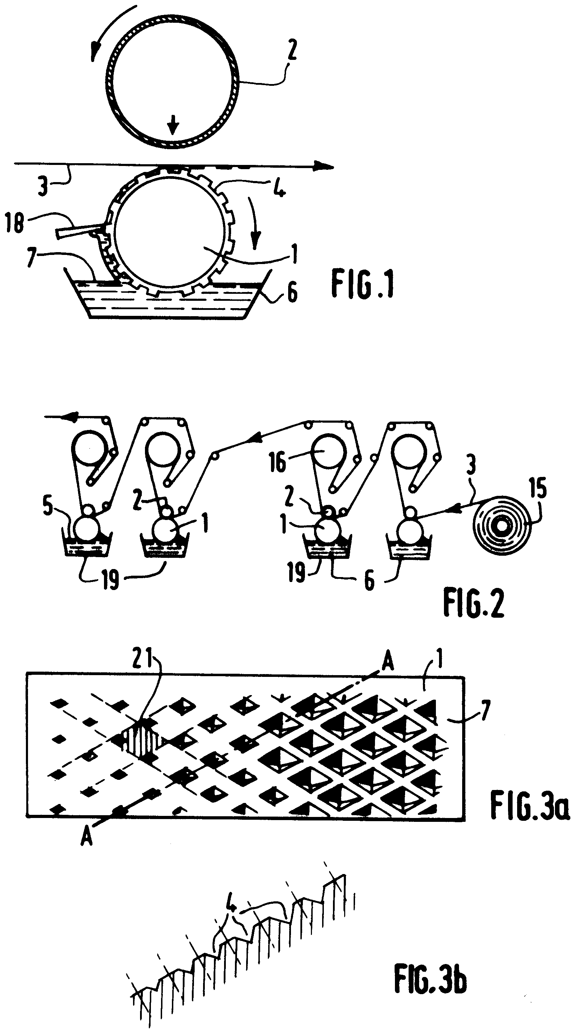

L'héliogravure est un procédé d'impression connu, basé sur le principe suivant :
a) Encrage de la forme imprimante :
   Un cylindre portant la forme imprimante gravée est encrée par trempage dans un encrier contenant une encre à solvants fluide et élimination, grâce à une racle appuyant sur ladite forme, de l'encre excédentaire débordant des alvéoles creuses de ladite forme imprimante gravée.
b) Transfert de encre :
   Le transfert de l'encre de ladite forme au support à imprimer se fait par simple application, à l'aide d'un cylindre de pression, dudit support contre ladite forme.
c) Séchage de l'encre :
   Le support passe dans un sécheur où lesdits solvants sont éliminés, ce qui contribue à fixer l'encre sur ledit support. Voir figure 1.

Les supports d'impression sont généralement des matériaux en bobines (papier, plastique, métal....). Ils sont imprimés sur des rotatives hélio comprenant autant de blocs encreurs que de couleurs à déposer. Voir figure 2.

Les procédés d'héliogravure sont décrits dans de nombreux ouvrages, par exemple dans "Les applications nouvelles des procédés d'impression" de Pierre DURCHON, Editions du Moniteur, PARIS, 1989 (voir chapitre II, pages 127 à 138).

Les procédés d'héliogravure se caractérisent par l'emploi de formes imprimantes gravées en creux. Il existe différents procédés de gravure, notamment la gravure chimique et la gravure mécanique. Cependant, actuellement, la presque totalité des procédés de gravure utilisés dans l'industrie de l'imprimerie par héliogravure relèvent de la gravure mécanique sur cuivre par stylet diamanté. Un dispositif typique pour mettre en oeuvre ce type de gravure est l'HELIO-KLISCHOGRAPH (R) qui réalise, de manière automatisée, la gravure par pénétration contrôlée, à la surface en cuivre d'un cylindre, d'un stylet à extrémité "pyramidale". Les figures 3a et 3b correspondent à une gravure tramée obtenue par ce type de gravure.

Par cette technique, chaque creux ou alvéole de gravure a la forme d'une "pyramide" inversée, de profondeur et de base variables selon l'intensité requise pour chaque point de la trame. Le rapport profondeur/base est constant et caractérise l'angle au sommet du stylet - généralement de l'ordre de 130°. Lorsqu'un ton plein est recherché, la pénétration du stylet est maximum, de l'ordre de 40 µm, et alors la dite base recouvre la majeure partie de la surface dudit point de trame.

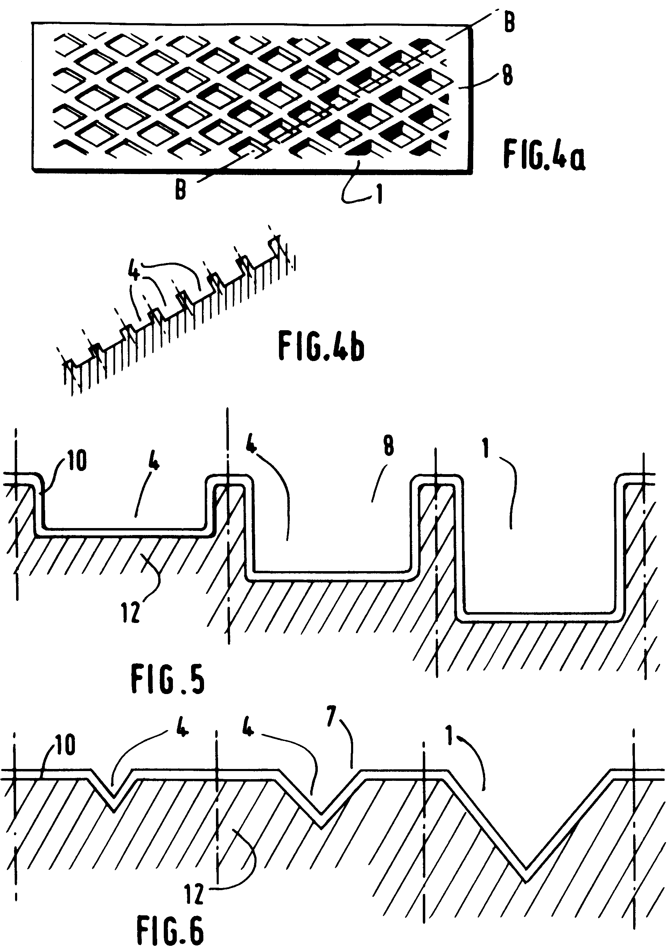

Généralement, après gravure et formation de creux ou alvéoles, un cylindre de cuivre, ou un cylindre ayant une couronne externe en cuivre, est chromé de manière à durcir toute sa surface, y compris l'intérieur des alvéoles, afin de limiter l'usure du cylindre qui résulterait de la pression permanente de ladite racle contre ledit cylindre en rotation. Voir figures 5 et 6.

Pour que le procédé d'impression par héliogravure fonctionne correctement, il importe que les alvéoles, au cours d'une même rotation du cylindre, se remplissent quand les alvéoles trempent dans l'encrier, puis se vident quand les alvéoles pleines sont au contact du support à imprimer.

Ceci nécessite, d'une part des encres relativement fluides, riches en solvants, et d'autre part une viscosité contrôlée de manière à avoir une encre aux propriétés rhéologiques sensiblement constantes, sous peine d'avoir des variations de teinte d'une impression à l'autre ou entre le début et la fin d'un même lot d'impression.
Les encres à solvants utilisées sont relativement diluées, avec une teneur en solvant, de l'ordre de 70% en volume, et de ce fait relativement "pauvres" en liant et en matière colorante, le plus souvent un pigment organique ou minéral. Ces solvants sont des solvants organiques du type cétones , alcools, hydrocarbures aromatiques (toluène), etc...

Une rotative hélio comprend, en tête de ligne, des moyens d'alimentation d'un support en bande (porte-bobines dérouleurs), puis autant d'éléments imprimants que de couleurs à déposer sur le support, et en queue de ligne, un porte-bobines enrouleur.
Chaque élément imprimant est doté de moyens de séchage de façon à ce que l'encre du support délivrée à l'élément imprimant "n" arrive sèche à l'entrée de l'élément suivant "n+1". Voir figure 2.

### PROBLEME POSE

L'impression par héliogravure est actuellement très utilisée, que ce soit dans le domaine de l'édition ou celui de l'emballage, en particulier grâce à la rapidité d'impression, la qualité des impressions et la grande souplesse du procédé (changement de format).

Cependant, cette technique d'impression se heurte à un problème qui prend de plus en plus d'importance, à savoir celui des solvants contenus dans les encres à solvants.
En effet, l'emploi d'encres à solvants, qui est inhérent au procédé conventionnel d'impression par héliogravure, pose de nombreux problèmes :
* d'une part, l'emploi d'encres à solvants pose un problème de sécurité, car les solvants utilisés sont inflammables, et peut poser aussi dans certains cas un problème de toxicologie dont la solution nécessite des précautions d'emploi particulières.
* d'autre part, l'emploi d'encres relativement diluées nécessite pour chaque élément imprimant des moyens de séchage importants, coûteux en investissements directs ou indirects (rotatives hélio de grande hauteur et longueur).
   Le coût d'exploitation dû aux solvants est également élevé compte tenu des contraintes légales relatives aux rejets ou effluents, que ce soit dans l'air ou dans l'eau, qui imposent un traitement spécifique des solvants évaporés.
* enfin, comme le séchage entre chaque élément imprimant nécessite le défilement d'une grande longueur de bande dans un four ou un dispositif de séchage, la longueur de bande engagée dans la rotative est globalement de plusieurs centaines de mètres, selon le nombre de blocs encreurs.

Comme, par ailleurs, dans le domaine de l'impression par héliogravure dans le secteur de l'emballage, la longueur moyenne d'un lot de production tend constamment à diminuer compte tenu d'une tendance à la personnalisation des produits, à une politique de crénaux dans la grande distribution, à la multiplication des "offres spéciales", à une rotation plus rapide des messages publicitaires, il en résulte, pour le fabricant d'emballages imprimés, une augmentation constante de la perte de support, ou gache, inévitable lors du démarrage, avec ses réglages, de la fabrication du lot imprimé, et lors de l'arrêt. Typiquement, chaque lot entraîne un gache correspondant en moyennne de 300 à 500 m de support en bande, ce qui constitue une perte de plus en plus significative compte tenu de la diminution de longueur moyenne de chaque lot.
La demanderesse a donc cherché à mettre au point un procédé d'impression par héliogravure résolvant tous ces problèmes.

### DESCRIPTION DE L'INVENTION

Le procédé d'impression en héliogravure comprend, a) l'utilisation de cylindres gravés en creux (creux unitaires appelés aussi "alvéoles") et tramés assurant, par rotation desdits cylindres et à l'aide d'une racle, un transfert d'encre entre un encrier et un support à imprimer en bande, b) l'utilisation d'encres liquides fluides chargées de matières colorantes, et c) l'utilisation de moyens de séchage de l'encre, et est caractérisé en ce que,
1) on utilise un cylindre gravé dont les alvéoles sont de profondeur constante et de surface variable dans les limites de la surface du point de trame.
2) on utilise des encres liquides sans solvant comprenant des monomères ou oligomères liquides, de viscosité adaptée au transfert d'encre depuis l'encrier jusqu'au support final, via lesdites alvéoles dudit cylindre gravé à alvéoles de profondeur constante, et de vitesse de polymérisation inférieure à 1 s,
3) on utilise, comme moyen de séchage, tout moyen connu pour fournir l'apport d'énergie nécessaire pour obtenir ladite vitesse de polymérisation.

L'invention porte donc sur une combinaison de deux familles de moyens :
* d'une part, l'utilisation de cylindres gravés dont les alvéoles sont de profondeur constante, et de surface variable, la surface maximum étant inférieure à la surface du point de trame. Celle-ci, standard, est assez petite pour ne pas être perçue à l'oeil nu, et assez grande pour que la durée de gravure ne soit pas prohibitive. Typiquement, le point de trame a la forme d'un carré ou d'un losange de côté de l'ordre de 50-100 µm.
* d'autre part, l'utilisation d'encres liquides, à la fois suffisamment fluides pour que soient remplies les alvéoles lors du trempage de chaque cylindre dans son encrier, et qu'elles soient vidées au moins partiellement lors du contact de ces alvéoles remplies et dudit support à imprimer, et aussi rapidement réticulables grâce à des moyens de séchage en eux-mêmes connus.

L'idée d'utiliser des encres sans solvants réticulables est déjà connue dans le domaine des encres offset.
Par contre, on ne connaît pas de procédé industriel d'impression par héliogravure utilisant des encres sans solvant.
Essayant de transposer à l'héliogravure l'enseignement connu dans le domaine de l'offset, la demanderesse s'est heurtée à deux types de difficultés :
A) D'une part, les cylindres gravés de manière conventionnelle, qu'il s'agisse de gravure mécanique par stylet ou de gravure chimique classique qui était très utilisée avant que ne s'impose la gravure mécanique par stylet, ne conviennent pas à l'utilisation d'encres sans solvant et, d'après les essais de la demanderesse, ne semblent pas pouvoir être adaptés à l'utilisation d'encre sans solvants.
   En effet, les techniques mêmes de gravure mécanique et chimique classiques conduisent à une formation de creux ou alvéoles de grande profondeur - typiquement 40 µm comme profondeur maximale - adaptée à des encres à solvant relativement "pauvres" en matières colorantes, mais inadaptée à des encres sans solvant relativement "riches" en matières colorantes.
   Cette gravure profonde, utilisée avec des encres sans solvant, conduit à une saturation de couleur trop grande, puisque trop de matière colorante est transférée par chaque alvéole.
   La demanderesse a essayé de diminuer la profondeur de gravure mais elle a constaté ce qui suit :
   * avec le procédé de gravure mécanique à stylet, la diminution de profondeur de gravure ne convient pas car, dans ce procédé, la surface de gravure varie comme la profondeur de gravure, de sorte que travailler à plage de profondeur réduite revient à ne graver qu'une fraction réduite de la surface du point de trame, ce qui n'est pas acceptable sur le plan du rendu coloristique. N'est pas davantage acceptable, sur un plan économique, la diminution de la surface du point de trame, qui conduirait à augmenter considérablement le temps de gravure des cylindres.
   * avec le procédé de gravure classique, dans lequel les alvéoles sont à surface (section) constante et à profondeur variable, ou même dans le cas de la gravure classique autotypique, elle a observé des variations inacceptables de nuance et l'examen détaillé de l'origine de ces variations a montré qu'elles provenaient de l'irrégularité de profondeur des alvéoles quand celles-ci sont de faible profondeur.
      Des essais complémentaires ont montré que même une gravure chimique réalisée avec le plus grand soin ne permettait pas de garantir une maîtrise de la profondeur des alvéoles et donc du volume d'encre à transférer par chaque alvéole.
      La demanderesse en a donc conclu à la nécessité d'écarter la gravure chimique classique pour résoudre les problèmes posés.

   Par contre la demanderesse, explorant une voie différente, a trouvé un élément de solution au problème en utilisant une gravure à profondeur constante et à surface variable.
B) D'autre part, les encres sans solvant et à séchage rapide utilisées en offset ne conviennent pas en hélio car beaucoup trop visqueuses (viscosité de l'ordre de 100 cP pour une encre pour héliogravure contre plusieurs milliers de cP pour une encre offset), une dilution par un solvant étant exclue par définition.
   Ainsi, la demanderesse a dû mettre au point des encres,
   a) de viscosité relativement basse adaptée à la gravure en creux des cylindres d'héliogravure selon l'invention,
   b) de pouvoir colorant suffisant pour obtenir toute la palette de nuances requises.
   c) polymérisables ou réticulables rapidement.

On entend par "rapidement" une durée de polymérisation inférieure à 1 s, ce qui correspond à une polymérisation sur 1 m de bande pour une vitesse de bande de 60 m /min. En effet, d'une part, la vitesse sur ligne d'impression est typiquement comprise entre 60 et 240 m/min, et d'autre part un objectif de l'invention est de diminuer très fortement à la fois la longueur de bande engagée sur rotative et d'autre part la taille et le coût des moyens de séchage, de sorte qu'il est préférable que la durée de polymérisation de l'encre soit inférieure à 0,1 s.
S'il n'est pas nécessaire que la polymérisation de l'encre soit complète en un temps aussi court, il importe cependant qu'elle soit suffisamment avancée pour que l'encre déposée au bloc encreur "n" perde son tack, au moins en surface, de manière à adhérer fortement au support à imprimer sans risque d'être arrachée ou endommagée au bloc encreur "n+1".

Ainsi, la solution aux problèmes posés passe par la coopération des deux familles de moyens trouvés par la demanderesse (système de gravure / système d'encres adaptées à cette gravure et à polymérisation rapide). Cette coopération conduit à un résultat commun qui est, sur le seul plan coloristique, l'obtention reproductible de la même plage de nuances que celle qui peut être obtenue par les gravures classiques associés à des encres à solvants classiques, et cela, dans les conditions et avec les vitesses d'impression habituelles sur rotative pour héliogravure.

Par ailleurs, il ne serait pas possible d'utiliser une encre classique avec le type de gravure selon l'invention, ni réciproquement une encre et des moyens de séchage selon l'invention avec une gravure classique.

### DESCRIPTION DES FIGURES

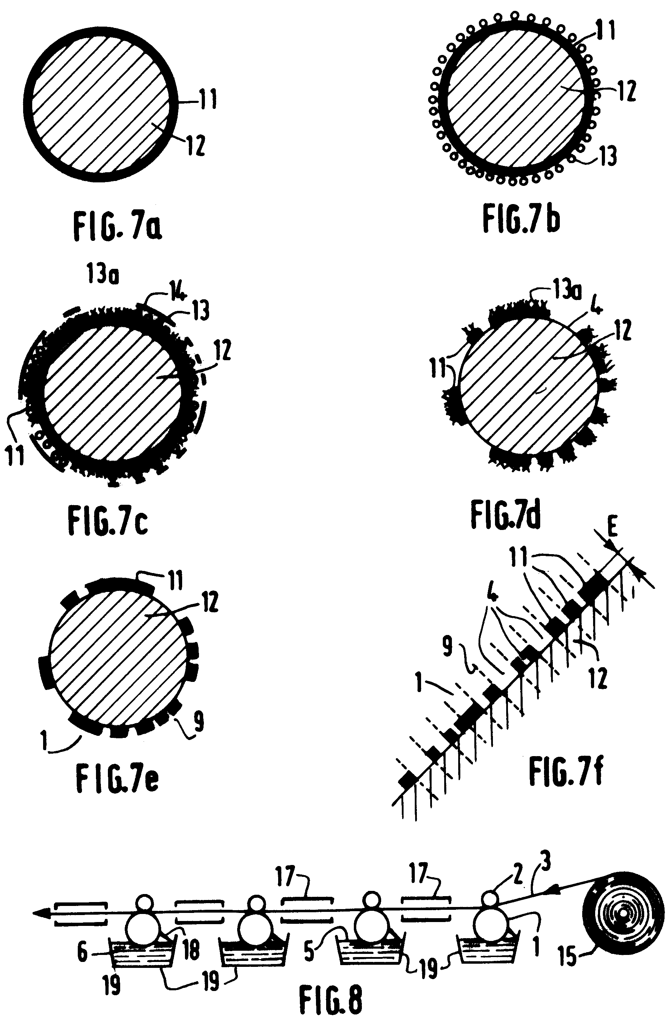

Les figures 1 à 6 correspondent à l'art antérieur. Les figures 7a à 7f et la figure 8 correspondent à l'invention.

La figure 1 schématise, en coupe, le principe de l'impression par héliogravure : un cylindre gravé (1) doté de creux ou alvéoles (4) transfère une encre (7) depuis un encrier (6) jusqu'à un support en bande (3) à imprimer, les alvéoles étant remplies dans l'encrier, vidées au contact du support à imprimer maintenu contre le cylindre gravé par un cylindre de contre-pression (2), et l'excès d'encre des alvéoles étant éliminé par une racle (18) de manière à assurer, pour une alvéole (4) donnée, un transfert d'un volume d'encre constant.

La figure 2 représente schématiquement, en coupe, une rotative pour héliogravure (20) classique, alimentée en support à imprimer (3) en bobine (15), et comprenant 4 blocs encreurs (19), chacun imprimant une encre (5) grâce à des cylindres gravés (1) transférant selon le motif de la gravure, l'encre de l'encrier (6) au support à imprimer (3). Chaque bloc encreur (19) comprend des moyens de séchage de l'encre (16) et d'élimination des solvants de l'encre (moyens non représentés).

Les figures 3a et 4a représentent une vue de dessus en perspective, respectivement d'une gravure tramée (7) obtenue par gravure mécanique, et d'une gravure tramée (8) obtenue par gravure chimique.
On a représenté sur la figure 3a, par le repère (21), un point de trame, surface unitaire (surface hachurée) au sein de laquelle s'inscrit la surface variable de chaque alvéole.

Les figures 3b et 4b représentent des coupes, respectivement selon la ligne A-A de la figure 3a et selon la ligne B-B de la figure 4a, montrant le profil des alvéoles (4) selon le type de gravure.
Dans le cas d'une gravure mécanique (7), la profondeur et la surface (ou ouverture) d'une alvéole varient simultanément, tandis que dans le cas d'une gravure chimique, la profondeur seule varie, la surface (ou ouverture) de chaque alvéole restant constante quelle que soit la profondeur des alvéoles.

Les figures 5 et 6 représentent des coupes de gravures tramées, analogues à celles des figures 3b et 4b, la figure 5 correspondant à la figure 4b agrandie, et la figure 6 correspondant à la figure 3b agrandie.
Sur ces figures, on a représenté un revêtement dur (10) de chrome qui recouvre un cylindre métallique (12) gravé mécaniquement (figure 6) ou chimiquement (figure 7), de manière à limiter l'usure des cylindres due à la racle ou à une éventuelle action abrasive des encres.

Les figures 7a à 7f sont relatives à l'invention et indiquent, par des représentations en coupe, comment on forme des cylindres gravés (1) dont les alvéoles (4) sont de profondeur constante et de surface variable dans les limites permises par la surface du point de trame, de manière à obtenir la gravure tramée (9) selon l'invention :
Figure 7a : dépôt d'une couche de chrome (11) d'épaisseur E constante et prédéterminée sur le cylindre métallique (12).
Figure 7b : dépôt ensuite d'une couche photosensible durcissable (13) à base de gélatine.
Figure 7c : application d'un positif (14) (soit tramé soit application d'une trame à part) de la photo à reproduire.
Figure 7d : insolation sous UV et développement (élimination de la couche photosensible non durcie) puis attaque chimique sélective du chrome et élimination du chrome dans les zones non protégées conduisant à la formation d'un cylindre gravé avec des alvéoles (4) de profondeur E constante et prédéterminée.
Figure 7e : après élimination des restes de la couche photosensible durcie (insolée), le cylindre gravé (1) selon l'invention est obtenu, la figure 7f montrant le détail de la structure de la gravure tramée (9) selon l'invention, avec des alvéoles de profondeur constante E, et de surface variable au sein de chaque point de trame. Sur les figures 3b, 4b et 7f, la périodicité de la trame a été symbolisée par des droites équidistantes en pointillés.

La figure 8, selon l'invention, est analogue à la figure 2 selon l'art antérieur. Elle montre une succession de 4 blocs encreurs (19), chacun suivi d'une enceinte de séchage UV (17), la circulation du support à imprimer (3) étant schématiquement rectiligne.

### DESCRIPTION DETAILLEE DE L'INVENTION

La première famille de moyens développés pour résoudre les problèmes posés concerne la gravure des cylindres.
Selon l'invention, pour obtenir lesdits cylindres gravés (1) à alvéoles de profondeur constante selon l'invention, on met en oeuvre, comme représenté aux figures 7a à 7f, une gravure sur cylindre métallique (12) comprenant les étapes suivantes :
a) on effectue d'abord un dépôt de chrome sur ledit cylindre métallique (12) de manière à obtenir une couche de chrome d'épaisseur E régulière et prédéterminée (11),
b) on enduit ensuite une couche photosensible durcissable (13) sur ladite couche de chrome,
c) on insole par rayonnement UV, à travers un positif photographique (14) éventuellement tramé, correspondant au cliché à reproduire, ladite couche photosensible durcissable (13) par action dudit rayonnement,
d) puis, on développe ladite couche photosensible par élimination de la partie de ladite couche photosensible non durcie après insolation,
e) enfin, on procède à une attaque chimique sélective du chrome sur toute ladite épaisseur prédéterminée, de manière à obtenir des alvéoles (4) de profondeur constante E égale à ladite épaisseur prédéterminée et de surface variable, le fond desdites alvéoles étant constitué par la surface dudit cylindre métallique (12), les parois desdites alvéoles étant constituées par la tranche de ladite couche de chrome d'épaisseur prédéterminée (11).

Alors que la profondeur de gravure selon l'art antérieur peut atteindre 40 µm, ladite profondeur constante E est comprise entre 2 et 10 µm, et elle est de préférence comprise entre 3 et 8 µm.

Les techniques de dépôt de chrome métallique sont en elles-mêmes connues, et font appel typiquement à un dépôt électrolytique. Ayant reconnu la nécessité d'une grande précision de la profondeur de gravure pour mettre au point le procédé selon l'invention, la demanderesse a aussi reconnu que les techniques de dépôt de chrome pouvaient être utilisées pour obtenir, sur l'ensemble de la surface cylindrique dudit cylindre métallique (12) une couche de chrome d'épaisseur constante, "constante" signifiant que l'épaisseur est partout égale à la valeur nominale de ladite épaisseur prédéterminée +/- 1,5 µm.
A titre indicatif, la technique de gravure chimique utilisée antérieurement conduisait à une variation de profondeur de l'ordre de +/- 3 à 6 µm, pour une valeur nominale visée de 10 µm par exemple. Ceci illustre bien que la gravure chimique classique ne pouvait convenir dans le cas d'une gravure de faible profondeur.

En ce qui concerne ladite attaque chimique sélective, les moyens pour développer ladite gravure par une attaque chimique sont choisis parmi les acides qui attaquent le chrome sans attaquer le métal constituant ledit cylindre métallique (12), ou du moins qui attaquent le chrome bien plus rapidement que ledit métal (typiquement au moins 5 fois plus vite). C'est le cas par exemple de l'acide chlorhydrique, dans le cas où ledit métal est du cuivre.

Les cylindres métalliques (12) utilisés selon l'invention sont, de préférence, soit ceux, en cuivre, utilisés pour la gravure conventionnelle, soit des cylindres en acier ou en aluminium.

De préférence, on utilise des cylindres en cuivre, car dans ce cas, il est facile, d'une part, d'adapter le diamètre de ces cylindres par dépôt électrolytique de cuivre, et d'autre part de déposer une couche de chrome pour mettre en oeuvre l'invention.

En ce qui concerne la deuxième famille de moyens développés pour résoudre les problèmes posés, la demanderesse n'a pas pu utiliser, pour des raisons déjà indiquées, les encres à séchage rapide déjà connues en impresion offset.

Elle a donc recherché des monomères ou oligomères pouvant satisfaire à la double exigence de :
- posséder une fluidité suffisante, même chargés de matière colorante, pour qu'un transfert d'encre satisfaisant de l'encrier jusqu'au support imprimé puisse avoir lieu,
- posséder une réactivité suffisante, c'est à dire une vitesse de polymérisation ou de réticulation inférieure à 1 s, étant entendu qu'une telle vitesse de polylméristion ne doit faire appel qu'à des moyens de séchage usuels, excluant tout équipement de coût et de volume prohibitif.

La demanderesse a étudié des monomères ou oligomères appartenant à des familles de produits chimiques susceptibles de satisfaire aux exigences précédentes, en particulier la famille des monomères acryliques, déjà utilisés en offset avec séchage UV, séchage qui induit une polymérisation radicalaire des monomères acryliques.

Mais, la demanderesse a obtenu les résultats les plus favorables en utilisant des monomères ou oligomères comprenant un groupement époxyde et une fonction susceptible de réagir avec le groupement époxyde.
Ainsi, lesdits monomères ou oligomères liquides sont choisis, de préférence, parmi les monomères ou oligomères à fonction époxyde.
Mais on peut aussi utiliser des mélanges de monomères ou oligomères comprenant, outre des monomères ou oligomères ayant un groupement époxyde, d'autres monomères ou oligomères (éthers vinyliques, dérivés acryliques réactifs, etc...).

Une formulation d'encre selon l'invention utilise des constituants connus en eux-mêmes et comprend typiquement :
A = un monomère / oligomère à groupements époxyde (seul ou en mélange avec d'autres monomères ou oligomères), de basse viscosité,
B = un diluant réactif de très basse viscosité,
C = un photo-initiateur,
D = un tensio-actif,
E = un pigment.

Selon une formulation typique, on peut avoir :
A : de 10 à 30 % en poids
B : de 55 à 80 % en poids
C : de 1 à 5 % en poids
D : moins de 2 % en poids
E : de 5 à 20% en poids

A titre indicatif, on peut choisir pour A) des monomères à 2 groupements époxyde ayant une viscosité inférieure à 500 cP à 25°C.

Comme diluant réactif pour B), on peut choisir des divinyléthers ayant une viscosité inférieure à 20 cP à 25°C.
Avec ces constituants A) et B), on obtient des encres de viscosité suffisamment basse, typiquement de l'ordre de 100 cP à 25°C, adaptées à l'impression par héliogravure utilisant les cylindres gravés selon l'invention.
En ce qui concerne la nature chimique des constituants A et B, ce qui précède ne constitue pas une limitation de l'invention dans la mesure où l'homme du métier saura, grâce à l'invention, sélectionner d'autres produits chimiques adaptés à la mise en oeuvre du procédé selon l'invention.

En ce qui concerne les moyens de séchage de l'encre, ledit moyen de séchage (17) est choisi parmi les moyens, en eux-mêmes connus, pour réticuler des monomères, et mettant en jeu, soit un apport direct ou indirect de calories (rayonnement infra-rouge, chauffage par micro-ondes, par induction), soit un rayonnement électromagnétique énergétique (rayonnement UV ou gamma), soit un bombardement ionique ou électronique.
De préférence, ledit moyen de séchage met en jeu un rayonnement UV, éventuellement associé à un moyen de séchage complémentaire (rayonnement infra-rouge, micro-ondes...).

### EXEMPLE DE REALISATION

A) Fabrication d'un cylindre gravé (1) selon l'invention
Les figures 7a à 7f décrivent les différentes étapes du procédé utilisé :
* on a d'abord chromé par voie électrolytique un cylindre de cuivre (12) standard à surface rectifiée de manière à obtenir un couche de chrome de 8 µm d'épaisseur nominale.
* on a ensuite déposé sur la couche de chrome (11), et de manière connue en elle-même, une couche de matière photosensible (13) à base de gélatine (marque Reprochem (R)).
* après avoir placé un cliché transparent positif (14) à reproduire sur la couche photosensible (cliché spécial pour les tests coloristiques présentant toutes sortes de dégradés et de d'aplats) et avoir insolé l'ensemble, on obtient le durcissement de la couche photosensible insolée (13a), la partie non insolée (13) restant non durcie. Voir figure 7c.
* après avoir retiré le cliché transparent (14), le rouleau a été placé dans un bain de développeur Reprochem (R) pour éliminer la couche non durcie. Après séchage, le cylindre est placé dans un bain à base d'acide chlohydrique qui attaque sélectivement le chrome jusqu'à ce qu'il rencontre le cylindre de cuivre, et cela seulement aux endroits où la couche de chrome était accessible à l'attaque acide, et n'était donc pas recouverte d'une couche photosensible durcie par insolation. Voir figure 7d.
* après rincage et élimination des restes de couche photosensible (13a), on obtient le cylindre (1) gravé selon l'invention.
   Les mesures des profondeurs des alvéoles ont montré que la profondeur était égale à la valeur nominale de 8 µm +/- 0,5 µm, ce qui est une précision beaucoup plus grande que celle accessible par la gravure chimique traditionnelle.

B) On a fabriqué des encres pour chaque couleur primaire (jaune, magenta, cyan) selon deux formulations différentes (compositions pondérales) :

| CONSTITUANTS | COMPOSITIONS | |
|---|---|---|
| | Encre 1 | Encre 2 |
| A = CYRACURE (R) UVR6110 de UNION CARBIDE | 27 | 9 |
| B = RAPI-CURE DVE3 (R) | 60 | 78 |
| C = photoinitiateur du commerce | 3,5 | 3,5 |
| D = tensio-actif du commerce | 0,5 | 0,5 |
| E = pigment du commerce | 9 | 9 |

Les pigments utilisés sont, pour le bleu, le Bleu Irgalithe GLVO (R), pour le magenta, le Rubis Lutétia 4BDN (R), et pour le jaune, le Jaune Irgalithe LBT (R).

Les encres obtenues, thixotropes compte tenu de la charge pigmentaire et donc relativement pâteuses à froid et au repos, ont été rendues suffisamment fluides et aptes à être utilisées sur rotative en portant ces encres à une température de l'ordre de 40°C et en les maintenant en mouvement dans l'encrier par une pompe de circulation.

C) Les essais d'impression en trichromie ont été effectués sur papier couché (3) en bobine de 700 mm de largeur (15), sur rotative (20) à 3 blocs encreurs (19) équipée de cylindres gravés (1) et utilisant les 3 encres (pour chaque formulation) selon l'exemple.

On a disposé en sortie directe de chaque bloc encreur (19) une enceinte de séchage UV (17) de puissance adaptée à la vitesse de défilement du support (plusieurs lampes en parallèle sous forme de tubes d'une puissance de 500 W/cm), comme représenté à la figure 8.
Les essais ont été effectués à différentes vitesses : 80, 130 et 170 m/min.

### Résultats des essais :

* d'une part, sur le plan coloristique, les impressions obtenues présentent peu de différences avec les impressions traditionnelles, qu'il s'agisse de tons en dégradé ou de tons pleins.
* d'autre part, en ce qui concerne la mise en oeuvre elle-même, qu'il s'agisse de la fabrication des cylindres gravés, de fabrication des encres ou du réglage et de la conduite de la rotative pendant l'impression proprement dite, il n'est pas apparu de problèmes particuliers liés aux moyens spécifiques de l'invention.

### AVANTAGES DE L'INVENTION

Ces essais ont donc montré la validité du concept défini par l'invention en ce qui concerne la faisabilité technique.
Au-delà du seul bilan technique, ces essais ont confirmé le bilan économique global, très positif, du procédé selon l'invention :
* d'une part, la longueur de bande engagée sur la rotative était de 45 m (comptée de dérouleur à enrouleur), contre 350 m pour une configuration semblable avec des encres à solvants traditionnelles, ce qui diminue de quelques pour cent les pertes de support brut ou imprimé.
* d'autre part, la suppression des séchoirs à solvant et de la circulation de bande dans ces fours divise pratiquement par 2 le volume global d'une rotative et diminue d'environ 15 à 30% le coût en investissement d'une rotative.
* enfin, l'absence de solvants diminue tous les frais liés à leur stockage / récupération ou incinération, ce qui représente généralement à la fois un grand volume de stockage et de manutention.

Par ailleurs, compte tenu de la disparition des risques liés aux solvants, les encres utilisées n'étant pas et n'ayant pas à être volatiles, le risque d'incendie en particulier est fortement diminué, de sorte que le procédé selon l'invention rend l'impression par héliogravure beaucoup plus sûre et par ailleurs facilite la mise en conformité d'installations d'impression par héliogravure aux diverses normes d'hygiène, de sécurité ou d'implantations industrielles notamment en milieu urbain.

## Revendications

**1 -** Procédé d'impression en héliogravure comprenant, a) l'utilisation de cylindres gravés (1) en creux (creux = alvéoles (4)) et tramés assurant, par rotation desdits cylindres et à l'aide d'une racle (18), un transfert d'encre (5) entre un encrier (6) et un support à imprimer en bande (3), b) l'utilisation d'encres liquides fluides chargées de matières colorantes, et c) l'utilisation de moyens de séchage de l'encre (16,17), caractérisé en ce que
1) on utilise des cylindres gravés (1) dont les alvéoles (4) sont de profondeur constante et de surface variable dans les limites de la surface du point de trame (21).
2) on utilise des encres liquides (5) sans solvants comprenant des monomères ou oligomères liquides, de viscosité adaptée au transfert d'encre depuis l'encrier (6) jusqu'au support à imprimer (3), via lesdites alvéoles (4) des cylindres gravés (1) de l'étape 1), et de vitesse de polymérisation inférieure à 1 s,
3) on utilise, comme moyen de séchage, tout moyen connu pour fournir l'apport d'énergie adapté à ladite vitesse de polymérisation.

**2 -** Procédé selon la revendication 1 dans lequel, pour obtenir lesdits cylindres gravés (1) de l'étape 1), on met en oeuvre une gravure sur cylindre métallique (12) comprenant les étapes suivantes :
a) on effectue d'abord un dépôt de chrome sur ledit cylindre métallique (12) de manière à obtenir une couche de chrome d'épaisseur E régulière et prédéterminée (11),
b) on enduit ensuite une couche photosensible durcissable (13) sur ladite couche de chrome,
c) on insole par rayonnement UV, à travers un positif photographique (14) éventuellement tramé, correspondant au cliché à reproduire, ladite couche photosensible durcissable (13) par action dudit rayonnement,
d) puis, on développe ladite couche photosensible par élimination de la partie de ladite couche photosensible non durcie après insolation,
e) enfin on procède à une attaque chimique sélective du chrome sur la totalité de ladite épaisseur prédéterminée E, de manière à obtenir des alvéoles (4) de profondeur constante E égale à ladite épaisseur prédéterminée et de surface variable, le fond desdites alvéoles étant constitué par la surface dudit cylindre métallique (12), les parois desdites alvéoles étant constituées par la tranche de ladite couche de chrome d'épaisseur prédéterminée (11).

**3 -** Procédé selon la revendication 2 dans lequel ladite profondeur constante E est comprise entre 2 et 10 µm.

**4 -** Procédé selon la revendication 3 dans lequel ladite profondeur constante E est comprise, de préférence, entre 3 et 8 µm.

**5 -** Procédé selon une quelconque des revendications 1 à 4 dans lequel ladite profondeur constante E est égale à la valeur nominale de ladite épaisseur prédéterminée +/- 1,5 µm.

**6 -** Procédé selon une quelconque des revendications 1 à 5 dans lequel lesdits monomères ou oligomères liquides sont choisis, de préférence, parmi les monomères ou oligomères à fonction époxyde.

**7 -** Procédé selon une quelconque des revendications 1 à 6 dans lequel ledit moyen de séchage (17) est choisi parmi les moyens, en eux-mêmes connus, pour réticuler des monomères, et mettant en jeu, soit un apport direct ou indirect de calories (rayonnement infra-rouge, chauffage par micro-ondes, par induction), soit un rayonnement électromagnétique énergétique (rayonnement UV ou gamma), soit un bombardement électronique.

**8 -** Procédé selon la revendication 7 dans lequel, de préférence, ledit moyen de séchage met en jeu un rayonnement UV, éventuellement associé à un moyen de séchage complémentaire (rayonnement infra-rouge, micro-ondes...).

**9 -** Procédé selon une quelconque des revendications 1 à 8 dans lequel ledit cylindre métallique (12) est, de préférence, un cylindre soit de cuivre, soit d'acier, soit d'aluminium.

**10 -** Procédé selon une quelconque des revendications 1 à 9 dans lequel les moyens pour développer ladite gravure par une attaque chimique sont choisis parmi les acides qui attaquent le chrome sans attaquer ledit cylindre métallique (12).
